# EUROPEAN PATENT APPLICATION

(11) **EP 0 551 756 A1**
(43) Date of publication of application: **21.07.1993**
(21) Application number: 92311672.7
(22) Date of filing: 21.12.1992
(51) Int. Cl.: G11C 14/00, G11C 11/22

(54) **Memory cell with ferro-electric capacitors**

(30) Priority: 20.12.1991 US 810975
(71) Applicant: TEXAS INSTRUMENTS INCORPORATED, Dallas Texas 75265 (US)
(72) Inventor: Shah, Ashwin H., Dallas, Texas 75243 (US)
(74) Representative: Blanco White, Henry Nicholas

(57) **Abstract**

A memory cell (10, FIGURE 1) is disclosed comprising a latch having two voltage terminals (28 and 30) for storing a data value and its inverse. A ferro-electric capacitor (54 and 56) is coupled to each terminal and to a voltage supply source. 5 Circuitry (58) is provided for alternately reading and writing voltage levels to the two voltage terminals. The ferro-electric capacitors are able to maintain a charge in a stand-by mode to the latch with low power loss and in a package size compatible with VLSI techniques.

## Description

### TECHNICAL FIELD OF THE INVENTION

This invention relates to integrated circuits, and more particularly to a memory cell circuit.

### BACKGROUND OF THE INVENTION

In contemporary memory technology, static random access memory (SRAM) cells may be constructed in various circuit configurations. These circuits are constructed in order to provide data retention capabilities while minimizing power requirements, current leakage and overall device size. Consequently, it is desirable to construct a memory cell with a minimum number of components. For each component within the cell, there must also be consideration of the component size and both internal and external interconnections to the component.

A typical contemporary SRAM cell is constructed in a 4T-2R configuration ("T" for transistor, "R" for resistor). Although the 4T-2R cell is compact, the resistors require the design engineer to make a compromise between two competing design goals. The resistors may be either large or small. In the first case, large resistors with high resistance lead to low current dissipation in the standby mode and thus low power consumption. Unfortunately, the larger the resistors are, the fewer may be fit into a given area. In the second case, many small resistors may be fit into a given integrated circuit. Unfortunately, the smaller the resistor, the lower the resistance and the greater the power dissipation and consequent heat generation. Memory cells fabricated with resistors also are prone to "soft errors," or are sensitive to line noise. Resistors, in general, do no maintain voltages at nodes to which they are connected when the power supply, word line or bit line contains voltage perturbations. If one of these signals contains a spike, then the transistors may change state inadvertently when the resistor passes the transient voltage level to the particular transistor.

An alternative to the 4T-2R cell has previously been constructed utilizing switched capacitive resistances that do not dissipate heat in the standby mode. This device requires six transistors and relatively sophisticated clocking circuitry to effect a capacitive resistance with sets of timed transistors. Such so-called 6T memory cells require a total of six transistors with numerous interconnections to the gates, sources and drains of these transistors. Each interconnection consumes much needed surface area on the device. As a result, device sizes and costs are increased 6T cells, along with increased device capacitance and other problems associated with excessive interconnections.

Therefore, a need has arisen for a memory cell which includes a minimum number of components and associated interconnections, consumes minimal power and may be constructed within a small area.

### SUMMARY OF THE INVENTION

In accordance with the present invention, a memory cell circuit and the operation thereof are provided which substantially eliminates and prevents disadvantages and problems associated with prior memory cell devices.

The memory cell disclosed comprises a latch having two voltage terminals for storing a data value and its inverse. A ferro-electric capacitor is coupled to each terminal and to a voltage supply source. Circuitry is provided for alternately reading and writing voltage levels to the two voltage terminals.

The present invention provides numerous technical advantages over prior memory cell configurations. A memory cell constructed according to the present invention includes a minimal number of components connected to provide efficient data storage and retrieval. The small size of the invention makes it compatible with VLSI fabrication techniques.

Additionally, the use of ferro-electric capacitors in place of resistors reduces power consumption and thus heat dissipation of the cell. Such a consequence is critical in large scale memory arrays.

### BRIEF DESCRIPTION OF THE DRAWING

For a more complete understanding of the present invention and the advantages thereof, reference is now made to the following description taken in conjunction with the accompanying drawings in which:
FIGURE 1 illustrates a schematic of a memory cell constructed and operated in accordance with the present invention; and
FIGURE 2 depicts graphically the current leakage characteristics of the disclosed memory cell as a function of temperature and stored charge.

### DETAILED DESCRIPTION OF THE INVENTION

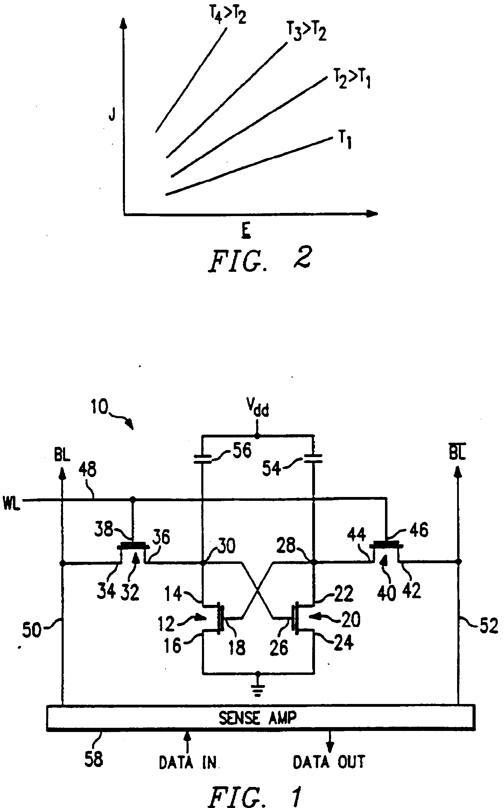

FIGURE 1 illustrates a memory cell 10 constructed and operated in accordance with the present invention, wherein ferro-electric capacitors are utilized to provide improved operating characteristics. Memory cell 10 includes a storage device comprising a first transistor 12 having a drain 14, a source 16 and a gate 18 and a second transistor 20 having a drain 22, a source 24 and a gate 26. First and second transistors 12 and 20 are connected in a crossed-coupled configuration. Accordingly, gate 18 of first transistor 12 is connected to drain 22 of second transistor 20. This gate-to-drain connection of first transistor 12 to second transistor 20 defines a first node 28. Similarly, gate 26 of second transistor 20 is connected to drain 14 of first transistor 12. This gate-to-drain connection of second transistor 20 to first transistor 12 defines a second node 30. The sources 16 and 24 of first and second transistors 12 and 20 are connected together and are further connected to ground.

Memory cell 10 further includes a first pass transistor 32 having a drain 34, a source 36 and a gate 38. Similarly, memory cell 10 includes a second pass transistor 40 including a drain 42, a source 44 and a gate 46. Sources 36 and 44 of pass transistors 38 and 46 are connected to second and first nodes 30 and 28 respectively. Gates 38 and 46 of pass transistors 32 and 40 are connected together and are further connected to a word line 48. Drain 34 of first pass transistor 32 is connected to a bit line 50. Drain 42 of second pass transistor 40 is connected to an inverted bit line 52. First and second nodes 28 and 30 are connected to a supply voltage, V_{dd}, through ferro-electric capacitors 54 and 56 respectively. As will be later described, capacitors 54 and 56 provide reduced current requirements and improved high temperature performances, while being fully compatible with VSLI technology and size requirements.

Although transistors 12, 20, 32 and 40 are depicted and described as FETs, it should be understood that other switching elements may be employed in memory cell 10. Consequently, drains and sources may be generically described as first and second poles respectively. Each set of first and second poles thus define a current path controlled by a "control electrode" or gate. Transistors 12 and 20 generically comprise a two terminal "latch" to which capacitors 54 and 56 are attached.

Both bit line 50 and inverted bit line 52 are connected to a sense amp 58. Sense amp 58 has an input for receiving data and an output for outputting data. It should be understood, as known in the art, that a plurality of cells 10 may be connected in an array wherein each column of the array has a single pair of write lines and each row has a word line.

Memory cell 10 operates in two different modes. The first mode is a non-access, standby or storage mode in which memory cell 10 retains a data value representative of either a binary zero or one. The second mode of operation for memory cell 10 is an access mode in which binary information is either read from or written to memory cell 10.

In the non-access mode, the word line signal and corresponding word line 48 are low. Accordingly, first and second pass transistors 32 and 40 are in a non-conducting state and therefore, cross-coupled transistors 12 and 20 are effectively isolated from bit line 50 and inverted bit line 52. In this mode, depending on the binary value stored by memory cell 10, either first transistor 12 or second transistor 20 is on while the opposing transistor is off. For example, consider the instance where first transistor 12 is on while second transistor 20 is off. With first transistor 12 on, second node 30 will be effectively coupled through transistor 12 to ground. Accordingly, gate 26 of second transistor 20, which is connected to second node 30, is low thereby maintaining second transistor 20 in a non-conducting state. With second transistor 20 in a non-conducting state, gate 18 of first transistor 12 is coupled through capacitor 54 to the supply voltage, V_{dd}. During the second or access mode for memory cell 10, the word line signal on word line 48 is high, causing pass transistors 32 and 40 to conduct. As a result, first and second nodes 28 and 30 are coupled through pass transistors 40 and 32 to inverted bit line 52 and bit line 50, respectively. Once this connection is established, memory cell 10 may either be written to or read from.

In order to write to memory cell 10 during the second mode wherein pass transistors 32 and 40 are conducting, data is transferred to sense amp 58 via its input. Sense amp 58 provides complementary signals to bit line 50 and inverted bit line 52 as known in the art. Accordingly, bit line 50 or inverted bit line 52 is grounded. As a result, cross-coupled transistors 12 and 20 may be maintained at their current state or may be switched to an alternative state. In order to read data from memory cell 10, sense amp 58 senses the relative amplitudes of the signals on bit line 50 and inverted bit line 52 and provides a data output via its output as known in the art.

Capacitors 54 and 56 should be constructed of a material which meets three design goals relating to high capacitance, high resistivity and desired temperature performance. In the preferred embodiment, all three of these goals are met.

First, capacitors 54 and 56 must have a high capacitance to decrease the power consumption and heat generation of memory all 10. Typically, capacitors 54 and 56 must have a capacitance of 0.1 to 0.2 pF. Heretofore, capacitor for use i integrated circuits have been constructed of simple dielectric materials such as SiO₂ and SiN₂. Although components having the requisite capacitance may be fabricated from these later materials, they will not be compatible with VLSI technologies. Capacitors fabricated from SiO₂, for instance, have a dielectric constant of approximately 12.

Second, capacitors 54 and 56 should have an equivalent resistance of 10¹⁰ to 10¹² Ohms. The charge accumulated at mode 28 and 30 will slowly dissipate or "trickle out" through other circuit elements in memory cell 10. This phenomenon requires that capacitors 54 and 56 be able to source some small but finite amount of current to modes 28 and 30 to ensure reliable operation of memory cell 10. A resistance of 10¹⁰ to 10¹² will allow the requisite amount of charge to trickle through to the two modes.

Third, the trickle current through capacitors 54 and 56 should increase with increasing temperature. The charge accumulated or modes 28 and 30 will dissipate more rapidly at elevated temperatures. FIGURE 2 depicts graphically the trickle current, "J," versus electric strength, "E," of such a capacitor. The trickle current is depicted for four temperatures, T₁, T₂, T₃, and T₄, each temperature higher than the previous. As indicated in FIGURE 2, the trickle current will increase for a given field strength as the temperature of the capacitor increases. The trickle current of a prior art capacitor fabricated from silicon dioxide, however, decreases as its temperature increases.

The class of ferro-electric materials have the requisite capacitance, resistance and temperature properties described above. Ferro-electric materials are crystalline compounds that exhibit a remnant dielectric polarization that may be reversed or reoriented by the application of an external electric field. The class includes such materials as lead zirconium titanate ("PZT"), barium titanate, and triglycine sulphate ("TGS"). In the preferred embodiment, capacitors 54 and 56 ar fabricated from PZT according to known methods to have a capacitance from 0.1 to 0.2 pF.

The resulting capacitors will have a resistance of 10¹⁰ to 10²¹ Ohms, will have suitable trickle current-temperature profile and will be small enough to be integrated into a 1 micron memory cell. It should be noted that due to the symmetric construction of memory cell 10, the selection of capacitor 56 is the same as that for capacitor 54.

Although the present invention and its advantages have been described in detail, it should be understood that various changes, substitutions and alterations can be made herein without departing from the spirit and scope of the invention as defined by the appended claims.

## Claims

1. A memory cell comprising:
a latch having a first and second voltage terminal for storing a data value;
a first ferro-electric capacitor coupled between the first terminal and a first voltage source;
a second ferro-electric capacitor coupled between the second terminal and the first voltage source; and
control circuitry for reading and writing voltage levels to the said terminals.

2. The memory cell of Claim 1 wherein said first and second ferro-electric capacitors are made of PZT.

3. The memory cell of Claim 1 wherein said latch comprises a first and second transistor, each transistor having a control electrode and a first and second pole defining a current path in each transistor, said first pole of each transistor coupled to the first and second voltage terminals respectively, said second pole of each transistor coupled to a second voltage supply, and said control electrodes of each transistor cross-coupled to said first pole of the other transistor.

4. The memory cell of Claim 3 wherein said first and second ferro-electric capacitors are made of PZT.

5. A memory cell comprising:
first and second transistors, said transistors each having a first and second pole defining a current path and a control electrode, said control electrode and said first pole of each transistor cross-coupled, and said second pole of each transistor coupled to a first voltage source;
a first ferro-electric capacitor coupled between the first pole of the first transistor and a second voltage source;
a second ferro-electric capacitor coupled between the first pole of the second transistor and the second voltage source; and
control circuitry for alternately sensing and changing the state of each transistor.

6. The memory cell of Claim 5 wherein the first and second ferro-electric capacitors are made of PZT.

7. A memory cell comprising:
first and second transistors, said transistors each having a first and second pole defining a current path and a control electrode, said control electrode and said first pole of each transistor cross-coupled, and said second pole of each transistor coupled to a first voltage source;
a first capacitor coupled between the first pole of the first transistor and a second voltage source, the capacitor having a leakage current that increases with increasing temperature;
a second capacitor coupled between the first pole of the second transistor and the second voltage source, the capacitor having a leakage current that increases with increasing temperature; and
control circuitry for alternately sensing and changing the state of each transistor.

8. The memory cell of Claim 7 wherein said first and second capacitors have an equivalent resistance of 10¹⁰ to 10¹² Ohms.
